# EUROPÄISCHE PATENTSCHRIFT

(11) **EP 2 913 920 B1**
(45) Veröffentlichungstag und Bekanntmachung des Hinweises auf die Patenterteilung: **26.12.2018**
(21) Anmeldenummer: 15156754.2
(22) Anmeldetag: 26.02.2015
(51) Int. Cl.: H02P 29/02, H02P 29/024, G01R 31/34, G01R 31/28, H03M 3/00, G05B 23/02, H03H 17/02

(54) **ELEKTRISCHES STEUERGERÄT**
ELECTRICAL CONTROL DEVICE
APPAREIL DE COMMANDE ÉLECTRIQUE

(30) Priorität: 27.02.2014 DE 102014203608
(43) Veröffentlichungstag der Anmeldung: 02.09.2015
(73) Patentinhaber: Lenze Automation GmbH, 31855 Aerzen (DE)
(72) Erfinder: Böltau, Manuel, 30159 Hannover (DE); Düsterberg, Dirk, 31860 Emmerthal (DE); Hohnsbein, Thorsten, 31855 Aerzen (DE); Krause, Andreas, 30974 Wennigsen (DE); Rehm, Dirk, 31840 Hessisch Oldendorf (DE); Wedemeyer, Torsten, 32457 Porta Westfalica (DE)
(74) Vertreter: Patentanwälte Ruff, Wilhelm, Beier, Dauster & Partner mbB

(56) Entgegenhaltungen:
- DE-A1- 19 934 296
- US-A- 4 305 076
- US-A1- 2013 278 197
- US-A1- 2013 285 579
- KHORBOTLY SAMI ET AL: "Recursive implementation of gaussian filters with switching and reset hardware", 2013 IEEE 56TH INTERNATIONAL MIDWEST SYMPOSIUM ON CIRCUITS AND SYSTEMS (MWSCAS), IEEE, 4. August 2013 (2013-08-04), Seiten 1399-1402, XP032525825, ISSN: 1548-3746, DOI: 10.1109/MWSCAS.2013.6674918 ISBN: 978-1-4799-4134-6 [gefunden am 2013-11-24]

## Beschreibung

Die Erfindung betrifft ein elektrisches Steuergerät zur Erzeugung mindestens eines Motoransteuersignals für einen Elektromotor, das einen Sigma-Delta-Modulator zur Digitalisierung analoger Signale aufweist.

Aus der DE 10 2011 080 586 A1 ist ein elektrisches Steuergerät in Form eines Frequenzumrichters bekannt, bei dem mittels eines Sigma-Delta-Modulators aus einem analogen Signal ein digitales Signal erzeugt wird.

Ein mittels des Sigma-Delta-Modulators erzeugter binärer Datenstrom wird üblicherweise mittels eines geeigneten digitalen Filters abtastratenreduziert und in digitale Daten mit mehreren Bit Breite gewandelt. Im Übrigen sei insoweit auch auf die einschlägige Fachliteratur verwiesen.

Die US 2013/0285579 A1 zeigt ein elektrisches Steuergerät zur Erzeugung von Motoransteuersignalen mit mehreren Delta-Sigma-Modulatoren, die dazu ausgebildet sind, in Abhängigkeit von den Motoransteuersignalen einen binären Datenstrom zu erzeugen. Den Delta-Sigma-Modulatoren nachgeschaltet sind ein Rückkopplungsfilter und ein weiteres digitales Filter.

Die DE 199 34 296 A1 zeigt eine Prüfanordnung für ein digitales elektronisches Filter, bei der der Ausgang des Filters auf einen Eingang des Filters in der Weise rückgekoppelt ist, dass das digitale Ausgangssignal des Filters als Prüfsignal am Eingang anliegt. Das Filter wird mit einem Testsignal beaufschlagt und das Antwortsignal wird als nächstes Testsignal auf den Eingang rückgekoppelt.

Der Erfindung liegt die Aufgabe zugrunde, ein elektrisches Steuergerät mit einem Sigma-Delta-Modulator zur Digitalisierung analoger Signale zur Verfügung zu stellen, das eine zumindest teilweise Überwachung der ordnungsgemäßen Funktion eines dem Sigma-Delta-Modulator nachgeschalteten digitalen Filters ermöglicht.

Die Erfindung löst diese Aufgabe durch ein Steuergerät nach Anspruch 1.

Das elektrische Steuergerät ist zur Erzeugung mindestens eines analogen Motoransteuersignals für einen Elektromotor ausgebildet. Das elektrische Steuergerät kann beispielsweise ein Frequenzumrichter sein, der dazu ausgebildet ist, analoge Motoransteuersignale bzw. Motoransteuerspannungen und/oder Motoransteuerströme zur Ansteuerung eines Drehstrommotors zu erzeugen. Insoweit sei auch auf die einschlägige Fachliteratur verwiesen.

Das elektrische Steuergerät weist einen herkömmlichen Delta-Sigma-Modulator auf, der dazu ausgebildet ist, in Abhängigkeit von dem mindestens einen Motoransteuersignal einen binären Datenstrom zu erzeugen, d.h. der binäre Datenstrom hängt in irgendeiner Art und Weise von dem Motoransteuersignal ab.

Das elektrische Steuergerät weist weiter eine Signalweichenschaltung mit einem ersten Ausgang und einem zweiten Ausgang auf. Die Signalweichenschaltung ist mit dem binären Datenstrom und einem digitalen Auswahlsignal beaufschlagt. Die Signalweichenschaltung ist dazu ausgebildet, den binären Datenstrom in Abhängigkeit von dem Auswahlsignal entweder an dem ersten Ausgang oder an dem zweiten Ausgang als ausgewähltem Ausgang auszugeben und an dem nicht ausgewählten Ausgang ein binäres Testsignal auszugeben. Mit anderen Worten ist die Signalweichenschaltung dazu ausgebildet, bei einem ersten Zustand (Null oder Eins) des Auswahlsignals den binären Datenstrom an dem ersten Ausgang auszugeben und das binäre Testsignal an dem zweiten Ausgang auszugeben und bei einem zweiten Zustand des Auswahlsignals (der komplementär zum ersten Zustand ist) das binäre Testsignal an dem ersten Ausgang auszugeben und den binären Datenstrom an dem zweiten Ausgang auszugeben.

Das elektrische Steuergerät weist weiter eine digitale Filtereinheit auf. Die digitale Filtereinheit weist ein erstes digitales Filter auf, das dazu ausgebildet ist, aus einem an dem ersten Ausgang der Signalweichenschaltung ausgegebenen Signal ein erstes gefiltertes Signal zu erzeugen. Die digitale Filtereinheit weist weiter ein zweites digitales Filter auf, das dazu ausgebildet ist, aus einem an dem zweiten Ausgang der Signalweichenschaltung ausgegebenen Signal ein zweites gefiltertes Signal zu erzeugen. Das erste und das zweite digitale Filter können typgleich sein und einen identischen Aufbau aufweisen. Das erste und das zweite digitale Filter können beispielsweise jeweils FIR-Filter sein, beispielsweise jeweils in Form von sinc-Filtern. Die gefilterten Signale können eine Folge von binären Daten sein oder eine Folge von Daten sein, die jeweils mehr als ein Bit umfassen. Der binäre Datenstrom kann eine Bitrate aufweisen, die größer ist als eine Bitrate oder Datenrate der gefilterten Signale, d.h. das erste und das zweite Filter können jeweils eine herkömmliche Bitratenreduktion durchführen. Insoweit sei auch auf die einschlägige Fachliteratur verwiesen.

Das elektrische Steuergerät weist weiter eine Summierschaltung auf, die dazu ausgebildet ist, in Abhängigkeit von dem ersten gefilterten Signal und dem zweiten gefilterten Signal ein Summensignal zu erzeugen. Im einfachsten Fall ist das Summensignal eine Summe aus dem ersten gefilterten Signal und dem zweiten gefilterten Signal.

Das elektrische Steuergerät weist weiter eine Auswerteschaltung auf, die mit dem Summensignal beaufschlagt ist und die dazu ausgebildet ist, in Abhängigkeit von dem Summensignal eine mit dem Motoransteuersignal korrespondierende Messgröße zu ermitteln. Bei der Messgröße kann es sich beispielsweise um einen Momentanwert eines Motorphasenstroms oder einer Motorphasenspannung handeln.

Das elektrische Steuergerät weist weiter eine Überwachungseinrichtung auf, die mit dem ersten gefilterten Signal und dem zweiten gefilterten Signal beaufschlagt ist und die dazu ausgebildet ist, das Auswahlsignal zu erzeugen und die Funktion der Filtereinheit zu überwachen, indem das aus dem binären Testsignal erzeugte gefilterte Signal mit einem Referenzsignal bzw. erwarteten Signal verglichen wird. Wenn das aus dem binären Testsignal erzeugte gefilterte Signal nicht mit dem Referenzsignal übereinstimmt, stellt die Überwachungseinrichtung einen fehlerhaften Betrieb der Filtereinheit bzw. des entsprechenden digitalen Filters fest. Wenn das aus dem binären Testsignal erzeugte gefilterte Signal mit dem Referenzsignal übereinstimmt, stellt die Überwachungseinrichtung einen fehlerfreien Betreib der Filtereinheit bzw. des entsprechenden digitalen Filters fest.

Die Signalweichenschaltung kann dazu ausgebildet sein, das binäre Testsignal als Folge von binären Nullen auszugeben. Diejenige Filtereinheit, die mit der Folge von binären Nullen beaufschlagt wird, erzeugt bei ordnungsgemäßer Funktion (zumindest nach einer Einschwingzeit) ein gefiltertes Signal mit Datenwerten jeweils mit einem Wert von Null (in digitaler Darstellung), d.h. das Referenzsignal ist für diesen Fall ebenfalls ein digitales Signal mit einem Wert von Null. Wenn das gefilterte Signal von Null abweichende Werte aufweist, kann folglich auf eine Fehlfunktion des digitalen Filters geschlossen werden. Bei ordnungsgemäßer Funktion ergibt sich als Summensignal ein von Testsignal unbeeinflusstes Signal, d.h. das Summensignal ist ausschließlich abhängig vom binären Datenstrom und wird nicht von dem Testsignal beeinflusst.

Die Signalweichenschaltung kann dazu ausgebildet sein, das binäre Testsignal während wiederkehrender Testzeitintervalle als Folge von binären Nullen und Einsen auszugeben. Für diesen Fall ist die Summierschaltung dazu ausgebildet, während der Testzeitintervalle (ggf. verlängert um etwaige Ein- und/oder Ausschwingzeiten) das aus dem binären Testsignal erzeugte gefilterte Signal zu unterdrücken. Diejenige Filtereinheit, die mit der Folge von binären Nullen und Einsen beaufschlagt wird, erzeugt bei ordnungsgemäßer Funktion ein vorbestimmtes bzw. vorhersagbares oder erwartetes gefiltertes Signal. Wenn das tatsächliche gefilterte Signal von dem erwarteten Signal bzw. Referenzsignal abweicht, kann folglich auf eine Fehlfunktion des digitalen Filters geschlossen werden. Um eine Beeinflussung des Summensignals durch das Testsignal zu vermeiden, wird dasjenige gefilterte Signal unterdrückt, das basierend auf dem Testsignal erzeugt wird.

Die Überwachungseinrichtung kann dazu ausgebildet sein, das Auswahlsignal als Rechtecksignal mit einer Frequenz zwischen 0,1 Hz und 100 Hz zu erzeugen. In diesem Takt wird folglich zwischen der Diagnose der digitalen Filter umgeschaltet, d.h. die digitalen Filter werden alternierend einer Diagnose unterzogen.

Die Erfindung ermöglicht es, eine komplexe digitale Filtereinheit mit Hilfe besonderer Diagnosemaßnahmen so weit im Normalbetrieb zu testen, dass diese außerhalb einer für Funktionale Sicherheitstechnik zertifizierten Schaltung platziert werden kann

Die Filterung des binären Datenstroms, d.h. des Ausgangssignals des Delta-Sigma-Modulators, erfolgt durch eine Filtereinheit mit zwei Filtern, die nicht notwendigerweise einer Zertifizierung nach Maßstäben der Funktionalen Sicherheitstechnik unterzogen werden müssen, da eine Diagnose der Filtereinheit bzw. deren Filter mit einem hohen Diagnosedeckungsgrad zur Laufzeit möglich ist. Das Summensignal wird durch das Testen nicht verfälscht. Die Diagnose kann zyklisch während des normalen Betriebs durchgeführt werden. Durch gezieltes Stimulieren der jeweiligen Filtereingänge lassen sich als Initialtest auch spezifische Fehlerzustände, z.B. Überstrom, testen. Durch Stimulation mit einem PWM-Signal lassen sich die Filter während des Betriebes mit beliebigen Modulationsgraden testen.

Erfindungsgemäß sind beispielswiese folgende Fehlfunktionen detektierbar: Fehlfunktion der Filtereinheit bzw. deren digitaler Filter, Einfrieren der digitalen Filtereinheit bzw. der digitalen Filter, unbeabsichtigte Änderung von Filterkoeffizienten der digitalen Filter sowie Gain-, Offset- und Kennlinien-Fehler.

Die Erfindung wird nachfolgend unter Bezugnahme auf die Zeichnungen detailliert beschrieben. Hierbei zeigt schematisch:
- Fig. 1: ein elektrisches Antriebssystem mit einem Elektromotor und einem erfindungsgemäßen Steuergerät zur Erzeugung von Motoransteuersignalen für den Elektromotor und
- Fig. 2: ein Blockschaltbild des in Fig. 1 gezeigten Steuergeräts.

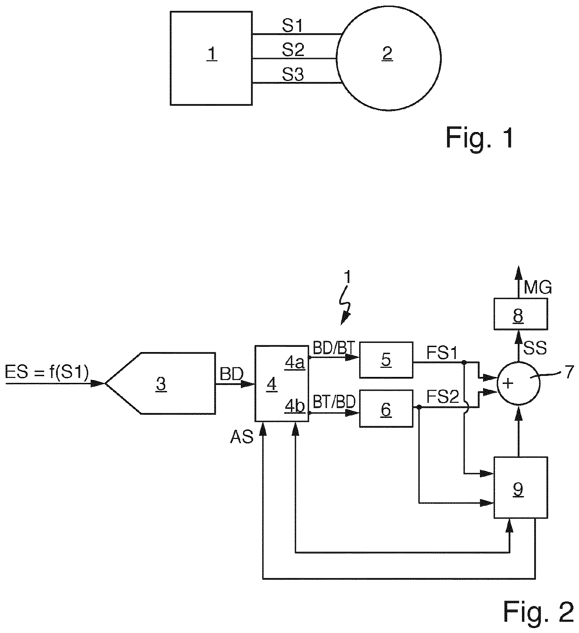

Fig. 1 zeigt ein elektrisches Antriebssystem mit einem dreiphasigen Elektromotor 2 und einem erfindungsgemäßen Steuergerät 1 in Form eines Frequenzumrichters zur Erzeugung von Motoransteuersignalen S1, S2 und S3 für eine jeweilige Phase des Elektromotors 2. Hinsichtlich der Erzeugung der Motoransteuersignale S1, S2 und S3 mittels Frequenzumrichtern sei auch auf die einschlägige Fachliteratur verwiesen.

Fig. 2 zeigt ein Blockschaltbild des in Fig. 1 gezeigten Steuergeräts 1. Es versteht sich, dass das Steuergerät 1 weitere nicht dargestellte Funktionsgruppen aufweisen kann.

Das Steuergerät 1 weist einen herkömmlichen Delta-Sigma-Modulator 3 auf, der dazu ausgebildet ist, in Abhängigkeit von einem analogen Eingangssignal ES, das von einem der Motoransteuersignale abhängt, vorliegend exemplarisch von dem Motoransteuersignal S1, d.h. es gilt ES = f (S1), einen binären Datenstrom BD zu erzeugen. Das Eingangssignal kann auch noch von weiteren Größen abhängig sein.

Das Steuergerät 1 weist weiter eine Signalweichenschaltung 4 mit einem ersten Ausgang 4a und einem zweiten Ausgang 4b auf, wobei die Signalweichenschaltung 4 mit dem binären Datenstrom BD und einem Auswahlsignal AS beaufschlagt ist. Die Signalweichenschaltung 4 ist dazu ausgebildet, den binären Datenstrom BD in Abhängigkeit von einem Zustand des Auswahlsignals AS entweder an dem ersten Ausgang 4a oder an dem zweiten Ausgang 4b auszugeben und an dem anderen Ausgang ein binäres Testsignal BT auszugeben.

Der Signalweichenschaltung 4 nachgeschaltet ist eine Filtereinheit, die ein erstes und ein zweites digitales Filter 5 bzw. 6 aufweist. Das erste digitale Filter 5 ist dazu ausgebildet, aus einem an dem ersten Ausgang 4a der Signalweichenschaltung 4 ausgegebenen Signal ein erstes gefiltertes Signal FS1 zu erzeugen. Das zweite digitale Filter 6 ist dazu ausgebildet, aus einem an dem zweiten Ausgang 4b der Signalweichenschaltung 4 ausgegebenen Signal ein zweites gefiltertes Signal FS2 zu erzeugen.

Eine Summierschaltung 7 ist mit den gefilterten Signalen FS1 und FS2 beaufschlagt und ist dazu ausgebildet ist, in Abhängigkeit von dem ersten gefilterten Signal FS1 und dem zweiten gefilterten Signal FS2 ein Summensignal SS zu erzeugen. Im einfachsten Fall entspricht das Summensignal exakt einer Summe der beiden Filtersignale FS1 und FS2.

Das Steuergerät 1 weist weiter eine Auswerteschaltung 8 auf, die mit dem Summensignal SS beaufschlagt ist und die dazu ausgebildet ist, in Abhängigkeit von dem Summensignal SS eine mit dem Motoransteuersignal S1 korrespondierende Messgröße MG zu ermitteln. Die Messgröße kann beispielsweise ein Wert einer Strangspannung oder eines Strangstroms sein.

Das Steuergerät 1 weist weiter eine Überwachungseinrichtung 9 auf, die mit dem ersten gefilterten Signal FS1 und dem zweiten gefilterten Signal FS2 beaufschlagt ist und die dazu ausgebildet ist, das Auswahlsignal AS zu erzeugen und die Funktion der Filtereinheit zu überwachen, indem das aus dem binären Testsignal BT erzeugte gefilterte Signal FS1 bzw. FS2 mit einem Referenzsignal bzw. einem zu erwartenden Signal verglichen wird. Stimmen gemessenes Signal und erwartetes Signal bzw. Referenzsignal nicht überein, wird auf eine Fehlfunktion, insbesondere der Filtereinheit, geschlossen. Für diesen Fall kann ein definierter bzw. sicherer Zustand des Steuergeräts 1 eingestellt werden.

Die Signalweichenschaltung 4 und die Überwachungseinrichtung 9 stehen, neben der Steuerung der Signalweichenschaltung 4 mittels des von der Überwachungseinrichtung 9 erzeugten Auswahlsignals AS, in bidirektionaler Signalverbindung.

In einer ersten Ausführungsform kann die Signalweichenschaltung 4 dazu ausgebildet sein, das binäre Testsignal BT selbstständig und unabhängig von der Überwachungseinrichtung 9 zu erzeugen. Für diesen Fall zeigt die Signalweichenschaltung 4 der Überwachungseinrichtung 9 an, in welcher Form das binäre Testsignal BT erzeugt wird. In Abhängigkeit von der Form des binären Testsignals BT wählt die Überwachungseinrichtung 9 dann ein geeignetes Referenzsignal bzw. erwartetes Signal aus, das mit dem gefilterten Signal FS1 bzw. FS2 verglichen wird.

In einer weiteren Ausführungsform kann (ausschließlich) die Überwachungseinrichtung 9 dazu ausgebildet sein, das binäre Testsignal BT zu erzeugen. Für diesen Fall wird das von der Überwachungseinrichtung 9 erzeugte binäre Testsignal BT von der Überwachungseinrichtung 9 an die Signalweichenschaltung 4 übertragen, wobei die Überwachungseinrichtung 9 das empfangene binäre Testsignal BT in Abhängigkeit von dem Auswahlsignal AS an dem ausgewählten Ausgang 4a bzw. 4b ausgibt.

Im einfachsten Fall ist die Signalweichenschaltung 4 bzw. die Überwachungseinrichtung 9 dazu ausgebildet, das binäre Testsignal BT als Folge von binären Nullen zu erzeugen. Für diesen Fall kann die Summierschaltung 7 das Summensignal SS als Summe der beiden Filtersignale FS1 und FS2 erzeugen. Im Fehlerfreien Betrieb wird ein Summensignal SS erzeugt, das einer herkömmlichen Schaltungsanordnung mit einer Filtereinheit mit nur einem einzelnen digitalen Filter entspricht, d.h. die Filterdiagnose während der Laufzeit ist für die Auswerteschaltung 8 transparent.

Die Signalweichenschaltung 4 bzw. die Überwachungseinrichtung 9 kann auch dazu ausgebildet sein, das binäre Testsignal BT während wiederkehrender Testzeitintervalle als PWM-Signal in Form einer Folge von binären Nullen und Einsen zu erzeugen. Um für diesen Fall keine Verfälschung des Summensignals SS zu verursachen, stehen die Signalweichenschaltung 4 bzw. die Überwachungseinrichtung 9 und die Summierschaltung 7 in Signalverbindung, so dass die Signalweichenschaltung 4 bzw. die Überwachungseinrichtung 9 der Summierschaltung 7 anzeigt, in welcher Form das binäre Testsignal BT erzeugt wird. Während des Erzeugens des binären Testsignals BT als PWM-Signal unterdrückt die Summierschaltung 7 das aus dem binären Testsignal BT erzeugte gefilterte Signal FS1 bzw. FS2 bei der Summenbildung, so dass keine Verfälschung des Summensignals SS verursacht wird.

Die Testzeitintervalle können beispielsweise eine Sekunde dauern und alle 10 Sekunden wiederholt werden.

## Patentansprüche

1. Elektrisches Steuergerät (1) zur Erzeugung mindestens eines Motoransteuersignals (S1) für einen Elektromotor (2), aufweisend:
- einen Delta-Sigma-Modulator (3), der dazu ausgebildet ist, in Abhängigkeit von dem Motoransteuersignal (S1) einen binären Datenstrom (BD) zu erzeugen,
- eine Signalweichenschaltung (4) mit einem ersten Ausgang (4a) und einem zweiten Ausgang (4b), wobei die Signalweichenschaltung (4) mit dem binären Datenstrom (BD) und einem Auswahlsignal (AS) beaufschlagt ist und dazu ausgebildet ist,
- den binären Datenstrom (BD) in Abhängigkeit von dem Auswahlsignal (AS) entweder an dem ersten Ausgang (4a) oder an dem zweiten Ausgang (4b) als ausgewähltem Ausgang auszugeben und
- an dem nicht ausgewählten Ausgang ein binäres Testsignal (BT) auszugeben,
- eine Filtereinheit, aufweisend
- ein erstes digitales Filter (5), das dazu ausgebildet ist, aus einem an dem ersten Ausgang (4a) der Signalweichenschaltung (4) ausgegebenen Signal ein erstes gefiltertes Signal (FS1) zu erzeugen,
- ein zweites digitales Filter (6), das dazu ausgebildet ist, aus einem an dem zweiten Ausgang (4b) der Signalweichenschaltung (4) ausgegebenen Signal ein zweites gefiltertes Signal (FS2) zu erzeugen, und
- eine Summierschaltung (7), die dazu ausgebildet ist, in Abhängigkeit von dem ersten gefilterten Signal und dem zweiten gefilterten Signal ein Summensignal (SS) zu erzeugen,
- eine Auswerteschaltung (8), die mit dem Summensignal (SS) beaufschlagt ist und die dazu ausgebildet ist, in Abhängigkeit von dem Summensignal (SS) eine mit dem Motoransteuersignal korrespondierende Messgröße (MG) zu ermitteln, und
- eine Überwachungseinrichtung (9), die mit dem ersten gefilterten Signal (FS1) und dem zweiten gefilterten Signal (FS2) beaufschlagt ist und die dazu ausgebildet ist,
- das Auswahlsignal (AS) zu erzeugen und
- die Funktion der Filtereinheit zu überwachen, indem das aus dem binären Testsignal (BT) erzeugte gefilterte Signal mit einem Referenzsignal verglichen wird.

2. Steuergerät nach Anspruch 1, **dadurch gekennzeichnet, dass**
- die Signalweichenschaltung (4) dazu ausgebildet ist, das binäre Testsignal (BT) als Folge von binären Nullen auszugeben.

3. Steuergerät nach Anspruch 1, **dadurch gekennzeichnet, dass**
- die Signalweichenschaltung (4) dazu ausgebildet ist, das binäre Testsignal (BT) während wiederkehrender Testzeitintervalle als Folge von binären Nullen und Einsen auszugeben,
- wobei die Summierschaltung (7) dazu ausgebildet ist, während der Testzeitintervalle das aus dem binären Testsignal erzeugte gefilterte Signal zu unterdrücken.

4. Steuergerät nach einem der vorhergehenden Ansprüche, **dadurch gekennzeichnet, dass**
- die Überwachungseinrichtung (9) dazu ausgebildet ist, das Auswahlsignal (AS) als Rechtecksignal mit einer Frequenz zwischen 0,01 Hz und 100 Hz zu erzeugen.

## Claims

1. Electrical control device (1) for generating at least one motor control signal (S1) for an electric motor (2), comprising:
- a delta sigma modulator (3) configured to generate a binary data stream (BD) in response to the motor control signal (S1),
- a signal splitter circuit (4) having a first output (4a) and a second output (4b), wherein the binary data stream (BD) and a selection signal (AS) are applied to the signal splitter circuit (4), and wherein the signal splitter circuit is configured to
- output the binary data stream (BD) in response to the selection signal (AS) either at the first output (4a) or at the second output (4b) as the selected output, and
- output a binary test signal (BT) at the not selected output,
- a filter unit, comprising
- a first digital filter (5) configured to generate a first filtered signal (FS1) from a signal output at the first output (4a) of the signal splitter circuit (4),
- a second digital filter (6) configured to generate a second filtered signal (FS2) from a signal output at the second output (4b) of the signal splitter circuit (4), and
- a summation circuit (7) configured to generate a sum signal (SS) in response to the first filtered signal and the second filtered signal,
- an evaluation circuit (8) to which the sum signal (SS) is applied and which is configured to obtain a measured parameter (MG) corresponding to the motor control signal in response to the sum signal (SS), and
- a monitoring device (9) to which the first filtered signal (FS1) and the second filtered signal (FS2) are applied and which is configured to
- generate the selection signal (AS), and
- monitor the function of the filter unit in that the filtered signal generated from the binary test signal (BT) is compared to a reference signal.

2. Control device according to claim 1, **characterized in that**
- the signal splitter circuit (4) is configured to output the binary test signal (BT) in a sequence of binary zeros.

3. Control device according to claim 1, **characterized in that**
- the signal splitter circuit (4) is configured to output the binary test signal (BT) during repeated test time intervals in a sequence of binary zeros and ones,
- wherein the summation circuit (7) is configured to suppress the filtered signal generated from the binary test signal during the test time intervals.

4. Control device according to any of the preceding claims, **characterized in that**
- the monitoring device (9) is configured to generate the selection signal (AS) as a square wave signal having a frequency between 0.01 Hz and 100 Hz.

## Revendications

1. Contrôleur électrique (1) destiné à générer au moins un signal d'excitation de moteur (S1) pour un moteur électrique (2), comprenant :
- un modulateur delta-sigma (3) qui est configuré pour générer un flux de données binaires (BD) en fonction du signal d'excitation de moteur (S1),
- un circuit séparateur de signal (4) doté d'une première sortie (4a) et d'une deuxième sortie (4b), le circuit séparateur de signal (4) étant alimenté avec le flux de données binaires (BD) et un signal de sélection (AS) et étant configuré pour
* délivrer le flux de données binaires (BD) soit à la première sortie (4a), soit à la deuxième sortie (4b) en fonction du signal de sélection (AS) sous la forme d'une sortie sélectionnée et
* délivrer un signal de test binaire (BT) à la sortie non sélectionnée,
- une unité de filtrage, comprenant
* un premier filtre numérique (5) qui est configuré pour générer un premier signal filtré (FS1) à partir d'un signal délivré à la première sortie (4a) du circuit séparateur de signal (4),
* un deuxième filtre numérique (6) qui est configuré pour générer un deuxième signal filtré (FS2) à partir d'un signal délivré à la deuxième sortie (4b) du circuit séparateur de signal (4), et
* un circuit additionneur (7) qui est configuré pour générer un signal total (SS) en fonction du premier signal filtré et du deuxième signal filtré,
- un circuit d'interprétation (8) qui est alimenté avec le signal total (SS) et qui est configuré pour déterminer une grandeur mesurée (MG) correspondant au signal d'excitation de moteur en fonction du signal total (SS), et
- un dispositif de surveillance (9) qui est alimenté avec le premier signal filtré (FS1) et le deuxième signal filtré (FS2) et qui est configuré pour
* générer le signal de sélection (AS) et
* surveiller le fonctionnement de l'unité de filtrage en comparant le signal filtré généré à partir du signal de test binaire (BT) à un signal de référence.

2. Contrôleur selon la revendication 1, **caractérisé en ce que** le circuit séparateur de signal (4) est configuré pour délivrer le signal de test binaire (BT) sous la forme d'une suite de zéros binaires.

3. Contrôleur selon la revendication 1, **caractérisé en ce que**
- le circuit séparateur de signal (4) est configuré pour délivrer le signal de test binaire (BT) pendant des intervalles de test périodiques sous la forme d'une suite de zéros et de uns binaires,
- le circuit additionneur (7) étant configuré pour, pendant les intervalles de test, inhiber le signal filtré généré à partir du signal de test binaire.

4. Contrôleur selon l'une des revendications précédentes, **caractérisé en ce que** le dispositif de surveillance (9) est configuré pour générer le signal de sélection (AS) sous la forme d'un signal rectangulaire ayant une fréquence comprise entre 0,01 Hz et 100 Hz.
